# FASCICULE DE BREVET EUROPEEN

(11) **EP 3 698 854 B1**
(45) Date de publication et mention de la délivrance du brevet: **10.04.2024**
(21) Numéro de dépôt: 19158483.8
(22) Date de dépôt: 21.02.2019
(51) Int. Cl.: A63B 5/11, A63B 71/06

(54) **PROCÉDÉ ET SYSTÈME DE MESURE DE PARAMÈTRES PHYSIQUES DANS UNE COMPÉTITION DE TRAMPOLINE**
MESSVERFAHREN UND -SYSTEM DER PHYSISCHEN PARAMETER IN EINEM TRAMPOLINWETTBEWERB
METHOD AND SYSTEM FOR MEASURING PHYSICAL PARAMETERS IN A TRAMPOLINE COMPETITION

(43) Date de publication de la demande: 26.08.2020
(73) Titulaire: Swiss Timing Ltd., 2606 Corgémont (CH)
(72) Inventeur: VARONE, Laurent, 2502 Bienne (CH)
(74) Mandataire: ICB SA

(56) Documents cités:
- EP-A1- 2 962 736
- WO-A1-2014/098628
- Christoph Lenk ET AL: "Evaluation eines Messsystems zur Bestimmung der Flugzeit und der Landepunkte im Trampolinturnen Potentialities for determining time of flight and positioning in competitive trampolining View project Trampletic View project Evaluation eines Messsystems zur Bestimmung der Flugzeit und der Landepunkte", , 28 février 2018 (2018-02-28), pages 1-16, XP055613361, Extrait de l'Internet: URL:https://www.researchgate.net/profile/K atja_Ferger2/publication/322924959_Evaluat ion_eines_Messsystems_zur_Bestimmung_der_F lugzeit_und_der_Landepunkte_im_Trampolintu rnen/links/5a76d4eaaca2722e4def9f6a/Evalua tion-eines-Messsystems-zur-Bestimmung-der- Flugzeit-und-der-Landepunkte-im-Trampolint urnen.pdf [extrait le 2019-08-16]
- Katja Ferger ET AL: "New way of determining horizontal displacement in competitive trampolining Potentialities for determining time of flight and positioning in competitive trampolining View project Trampletic View project", Article inScience of Gymnastics Journal, 31 janvier 2017 (2017-01-31), pages 303-310, XP055613364, Extrait de l'Internet: URL:https://www.researchgate.net/profile/K atja_Ferger2/publication/320540160_New_way _of_determining_horizontal_displacement_in _competitive_trampolining/links/59f9de7e45 8515de05ce5062/New-way-of-determining-hori zontal-displacement-in-competitive-trampol ining.pdf [extrait le 2019-08-16]

## Description

### Domaine de l'invention

L'invention concerne un procédé de mesure de paramètres physiques dans une compétition de trampoline.

L'invention concerne également un système de mesure de paramètres physiques dans une compétition de trampoline pour la mise en oeuvre du procédé de mesure.

### Arrière-plan de l'invention

Dans une compétition de trampoline, il peut être déterminé le temps de vol de l'athlète depuis le lit du trampoline et son déplacement horizontal pour l'attribution de points. Il est connu d'effectuer ces mesures au moyen de lasers et photocellules ou par des capteurs de force disposés sous les pieds du trampoline ou par paires de capteurs de mouvement disposées selon des axes orthogonaux. Cependant les systèmes de mesure connus sont difficiles à mettre en place et un manque de précision est constaté.

La gymnastique sur un trampoline est une discipline olympique dans laquelle des athlètes doivent effectuer dix sauts acrobatiques sur le lit du trampoline. Le score ou les points attribués se basent sur la difficulté, la forme du saut, le "temps de vol" (ToF) depuis le lit du trampoline et le déplacement horizontal depuis le centre du lit du trampoline.

Depuis plusieurs années, les points du temps de vol étaient additionnés au score total. Le temps de vol de chaque saut est ajouté et le temps total dans l'air donne les points du temps de vol. Plus l'athlète reste en l'air et plus les points du temps de vol sont meilleurs. La Fédération Internationale de Gymnastique (FIG) requière une précision de mesure du temps de vol de 5 ms.

Le déplacement horizontal au point d'atterrissage est aussi pris en compte pour déterminer le score et a besoin d'être mesuré. Pour ce faire, il y a différentes zones sur le trampoline, qui sont délimitées par des lignes rouges sur le lit. Chaque fois que l'athlète atterrit en dehors de la zone centrale, quelques points de déduction sont appliqués. De nos jours, ce contrôle est fait visuellement par des juges disposés dans l'entourage du trampoline avec l'aide d'un enregistrement vidéo. Il n'y a pas de détection automatique utilisée en compétition.

On peut citer la demande de brevet WO 2014/098628 A1, qui décrit un trampoline et un procédé de mesure de l'activité d'une personne sur un trampoline. Au moins deux paires de capteurs sont disposées en périphérie sur le trampoline pour déterminer une déformation du lit du trampoline lors de son utilisation par la personne. Les deux paires de capteurs sont disposées sur deux axes orthogonaux pour avoir des données selon un espace cartésien. Cet agencement de capteurs ne permet pas de déterminer précisément tout déplacement horizontal sur le lit et un temps de vol de la personne pour une compétition de gymnastique sur trampoline, ce qui constitue un inconvénient.

EP 2 962 736 A1 dévoile un trampoline muni d'un ensemble de capteurs au moyen desquels les forces ou les accélérations agissant sur la toile de saut sont détectées. Les signaux des capteurs sont lus dans une unité d'évaluation. Des grandeurs de sortie sont générées à partir de l'évolution temporelle des signaux.

### Résumé de l'invention

L'invention a donc pour but de pallier les inconvénients de l'état de la technique susmentionné en proposant un procédé de mesure de paramètres physiques dans une compétition de trampoline pour la détermination automatique et précise du nombre de sauts, du déplacement d'un athlète sur le lit du trampoline et du temps de vol pour l'attribution de points durant la compétition.

A cet effet, l'invention concerne un procédé de mesure de paramètres physiques dans une compétition de trampoline, qui comprend les caractéristiques définies dans la revendication indépendante 1.

Des étapes particulières du procédé de mesure sont définies dans les revendications dépendantes 2 à 9.

Un avantage du procédé de mesure réside dans le fait qu'il est prévu au moins quatre ensembles à capteur de mouvement disposés chacun respectivement par exemple au niveau d'un coin du trampoline pour fournir une fois activés et par périodes déterminées des informations de paramètres physiques mesurés durant la compétition. Les paramètres physiques sont notamment le temps de vol durant la compétition, tout mouvement de contact sur le lit du trampoline pour déterminer une position en combinaison des autres ensembles à capteur de mouvement.

Selon l'invention, chaque ensemble à capteur de mouvement est indépendant des autres ensembles à capteur de mouvement. De cette manière, la réception de tous les signaux de données de mesure des ensembles à capteur par une station de base du système permet de déterminer précisément et de manière automatique un temps de vol et une position précise sur le lit du trampoline d'un compétiteur pendant la compétition. Une attribution de points est automatiquement donnée par le système et sans l'aide d'un juge arbitre. De cette manière, chaque compétiteur aura au terme de sa prestation un nombre de points fournis exactement suite au calcul dans la station de base, qui comprend un ordinateur.

Avantageusement, une fois que les ensembles à capteur sont activés et éventuellement initialisés dès le début de la compétition, il est possible d'obtenir précisément toutes les mesures pour l'attribution de points durant la compétition, notamment dans un ordinateur relié sans fil aux ensembles à capteur.

A cet effet, l'invention concerne aussi un système de mesure de paramètres physiques dans une compétition de trampoline pour la mise en oeuvre du procédé de mesure, qui comprend les caractéristiques définies dans la revendication indépendante 10.

Des formes d'exécution du système de mesure sont définies dans les revendications dépendantes 11 à 14.

### Brève description des dessins

Les buts, avantages et caractéristiques du procédé et du système de mesure de paramètres physiques dans une compétition de trampoline selon l'invention apparaîtront mieux dans la description suivante d'au moins une forme d'exécution non limitative illustrée par les dessins sur lesquels :
la figure 1 représente une forme d'exécution simplifiée d'un ensemble à capteur de mouvement pour le système de mesure de paramètres physiques dans une compétition de trampoline selon l'invention, et
la figure 2 représente une forme d'exécution simplifiée d'un système de mesure de paramètres physiques dans une compétition de trampoline selon l'invention.

### Description détaillée de l'invention

Dans la description suivante, tous les éléments d'un système de mesure de paramètres physiques dans une compétition de trampoline, qui sont bien connus de l'homme du métier dans ce domaine technique, ne seront relatés que de manière simplifiée.

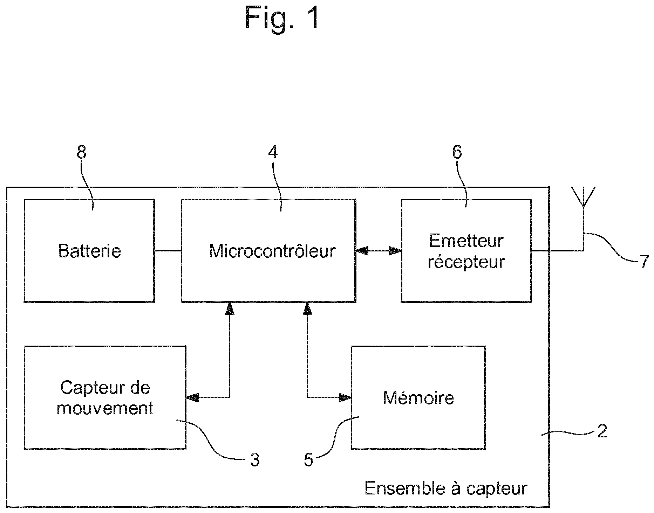

La figure 1 représente schématiquement les composants d'un ensemble 2 à capteur de mouvement pour une utilisation dans un système de mesure de paramètres physiques dans une compétition de trampoline. L'ensemble 2 à capteur comprend principalement au moins un capteur de mouvement 3, relié à une unité de traitement 4, qui peut être un processeur ou de préférence un microcontrôleur 4 afin de traiter les données de mesures du capteur de mouvement 3 dans le temps. L'ensemble 2 à capteur comprend encore des moyens d'émission et réception, tels qu'un émetteur/récepteur 6 relié au microcontrôleur 4 pour la transmission de signaux de données de mesures par une antenne 7, qui peut servir également à capter des signaux de configuration ou de commandes ou de paramétrage d'une station de base. L'ensemble 2 à capteur peut encore comprendre une mémoire 5 pour mémoriser des données de mesures notamment durant la compétition. Cette mémoire 5 peut être volatile ou non volatile, telle qu'une mémoire Flash. Une source d'alimentation, telle qu'une batterie 8 peut aussi être prévue pour l'alimentation électrique des composants de l'ensemble 2 à capteur.

Le capteur de mouvement 3 peut être composé d'au moins un accéléromètre et/ou d'un gyroscope. De préférence, le capteur de mouvement 3 peut être composé d'un accéléromètre triaxial, d'un gyroscope triaxial et d'un magnétomètre triaxial. Un algorithme d'exécution est mémorisé dans la mémoire 5 ou directement dans le microcontrôleur 4 pour détecter si le compétiteur durant la compétition est dans l'air ou non. Par une combinaison des signaux du gyroscope et de l'accéléromètre à une fréquence définie entre 1 kHz et 10 kHz, de préférence 2 kHz, cadencée par le microcontrôleur 4, il est possible d'obtenir une très bonne précision pour la détermination d'un temps de vol (ToF) du compétiteur sur un trampoline avec aucun retard durant la compétition.

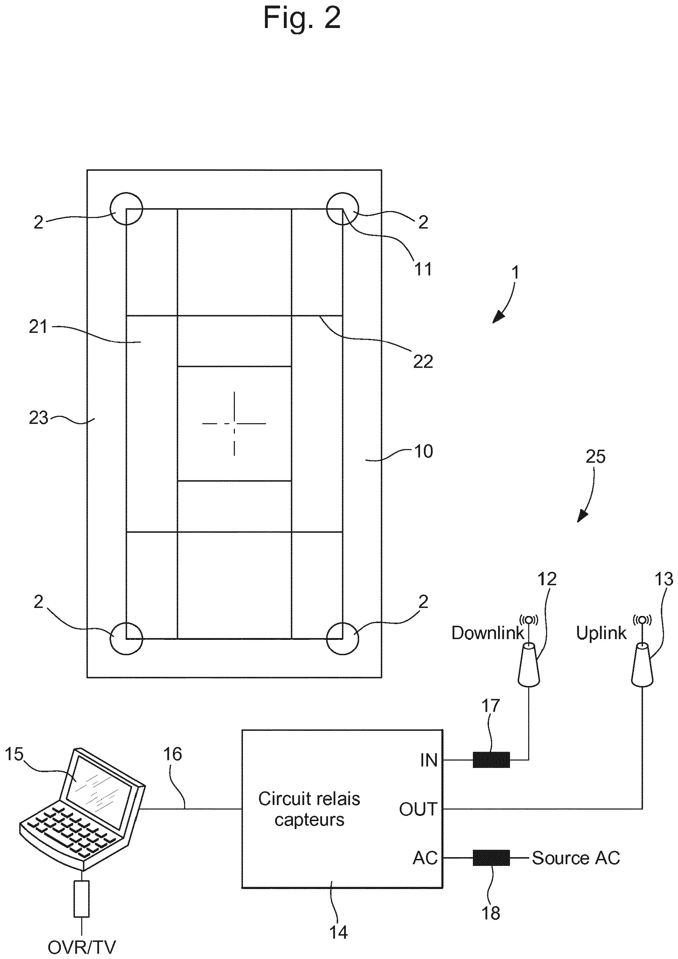

Pour le procédé de mesure de paramètres physiques sur le trampoline notamment durant une compétition, il est fait référence au système de mesure 1 présenté à la figure 2. Le système de mesure peut être mis en fonction au début d'une compétition de trampoline et permet d'effectuer toutes les mesures automatiquement pour chaque compétiteur et fournir un résultat ou attribuer un nombre de points personnalisé au compétiteur.

Le système de mesure 1 comprend plusieurs ensembles 2 à capteur de mouvement disposés dans différentes positions sur un trampoline 10, par exemple au niveau de coins 11, par exemple à quatre coins 11 du trampoline 10 de forme rectangulaire en vue de dessus. Il est de préférence prévu un ensemble 2 à capteur à chaque coin 11 du trampoline 10, c'est-à-dire à la liaison d'un lit 21 à un cadre 23 de bordure du trampoline, qui est lui-même fixé à des pieds non représentés pour le maintien du trampoline à distance d'un sol. Le lit 21 est généralement relié au cadre 23 de bordure par plusieurs ressorts hélicoïdaux non représentés. Lors d'un saut d'un compétiteur sur le lit 21 du trampoline 10, le capteur de mouvement de chaque ensemble 2 à capteur détecte un mouvement ou une variation de mouvement pour fournir des données de mesure dans le temps. Chaque ensemble 2 à capteur est indépendant de tout autre ensemble 2 à capteur pour pouvoir fournir des données de mesure indépendamment des autres ensembles 2 à capteur.

Il est à noter que chaque ensemble 2 à capteur de mouvement est disposé de préférence à un coin 11 respectif du lit 21 directement au niveau de la liaison des ressorts hélicoïdaux au lit 21. Une autre extrémité des ressorts est directement liée au cadre 23 du trampoline 10.

Grâce à l'agencement des ensembles 2 à capteur de mouvement sur le lit 21 du trampoline 10, il peut aussi être mesuré de manière précise le déplacement horizontal en prenant les mesures de chaque capteur activé des ensembles 2 à capteur indépendant l'un de l'autre. Chaque ensemble 2 à capteur peut transmettre son numéro d'identification dans le signal de données pour bien le différencier des autres ensembles 2 à capteur.

Une fois activé pour la compétition, les microcontrôleurs des ensembles sont cadencés par exemple à une fréquence de 2 kHz pour obtenir les mesures des capteurs de mouvement. Une mémorisation de chaque mesure dans la mémoire de chaque ensemble 2 à capteur peut être effectuée. Une transmission des signaux de données de mesures peut être effectuée depuis un émetteur de chaque ensemble 2 à capteur avec une identification de l'ensemble 2 à capteur pour une station de base 25, qui comprend un ordinateur 15 du système de mesure 1 en passant par une antenne de réception 12 (Downlink). Cette antenne de réception 12 peut être reliée à un circuit relais capteurs 14 de la station de base 25. Ce circuit 14 reçoit les signaux de mesure de l'antenne de réception 12 à une entrée IN. Ces signaux captés peuvent encore être filtrés par un filtre 17 fonction du pays de la compétition. Une connexion 16 par exemple filaire peut encore être effectuée entre le circuit relais 14 vers l'ordinateur 15 de gestion complète de la compétition et de tous les compétiteurs enregistrés. L'ordinateur 15 peut encore commander un affichage de résultats par des signaux OVR/TV ou transmettre des informations par un réseau informatique ou télévisuel.

Durant la compétition, l'ordinateur 15 peut recevoir les signaux de données de chaque ensemble 2 à capteur en fonction de manière à calculer précisément la position du compétiteur sur le lit 21 du trampoline. Des points sont attribués selon l'endroit de contact sur le lit à chaque saut du compétiteur tenant compte de la position des lignes rouges 22 tracées sur le lit 21. Les mesures des capteurs de mouvement des ensembles 2 à capteur sont bien différenciées selon la position de contact sur le lit 21 du compétiteur pour la détermination automatique précise des points. De plus, l'ordinateur 15 peut aussi déterminer le temps de vol du compétiteur pour attribuer d'autres points au compétiteur durant sa prestation en compétition. Toutefois, le temps de vol peut aussi être déterminé directement dans chaque ensemble 2 à capteur avant une transmission du signal de données de mesures.

Il est encore à noter que chaque fois que le trampoline est touché ou quitté par le compétiteur, les ensembles 2 à capteur de mouvement envoient également une estampille temporelle calculée en l'air dans les signaux de données. Un numéro d'identification de l'ensemble 2 à capteur peut encore être inséré dans les signaux de données transmis, qui sont généralement à faible fréquence. L'ordinateur 15 reçoit les estampilles temporelles et les convertit au temps correspondant du jour.

Depuis l'ordinateur 15, il peut être envoyé des commandes aux ensembles 2 à capteur. Ces signaux de commandes sont transmis par une antenne d'émission 13 (Uplink), qui est reliée à une sortie OUT du circuit relais 14. Ces signaux de commandes sont reçus par tous les ensembles 2 à capteur. Une base de temps de chaque microcontrôleur peut être adaptée suite à une synchronisation transmise par l'ordinateur 15. Ce circuit relais 14 peut encore être alimenté en électricité par une connexion à une source AC externe, c'est-à-dire au réseau électrique avec un transformateur 18 en entrée AC du circuit réseau 14.

Les signaux de commandes et leur effet à chaque ensemble 2 à capteur sont les suivants :
- Sélection d'un mode compétition, où les ensembles 2 à capteur et les algorithmes de détection sont activés.
- Sélection d'un mode pause (standby), où les capteurs et algorithmes de détection sont désactivés, mais les autres composants de chaque ensemble 2 à capteur sont enclenchés.
- Sélection d'un mode arrêt (shutdown), où chaque ensemble 2 à capteur est éteint.
- Effacement de mémoire, où toutes les données mémorisées des ensembles 2 à capteur sont effacées avant un nouveau compétiteur ou une nouvelle compétition.

Il est encore à noter que tous les ensembles 2 à capteur envoient un signal de statut périodiquement par exemple toutes les secondes, qui est capté par l'antenne 12 et transféré à l'ordinateur 15. L'état des ensembles 2 à capteur peut ensuite être visualisé sur l'ordinateur 15, notamment l'état des capteurs de mouvement, le niveau de la batterie, l'espace de stockage de la mémoire et d'autres états.

Quand les ensembles 2 à capteur sont en mode compétition, un algorithme de détection est activé pour détecter quand une personne ou un compétiteur entre en contact sur le lit 21 et quand la personne ou le compétiteur décolle. Chaque ensemble 2 à capteur fait sa propre détection indépendamment des autres ensembles 2 à capteur. A chaque détection d'atterrissage ou de décollage, un signal de données est envoyé avec le temps calculé. Tous les signaux de données sont reçus par l'antenne de réception 12 et transmis à l'ordinateur 15. Pour chaque saut de la personne ou du compétiteur, l'ordinateur traite l'information reçue des différents capteurs de mouvement pour calculer un temps de vol unique et une position précise sur le trampoline.

A partir de la description qui vient d'être faite, plusieurs variantes du procédé ou système de mesure de paramètres physiques dans une compétition de trampoline peuvent être conçues par l'homme du métier sans sortir du cadre de l'invention définie par les revendications. Il peut aussi être prévu d'alimenter chaque ensemble à capteur par des signaux de communication à basse fréquence captés par l'antenne du récepteur de chaque ensemble à capteur. La base de temps de chaque microcontrôleur peut être calibrée avant le début de chaque compétition. Il peut être prévu d'effectuer la mesure de paramètres physiques pour deux compétiteurs en même temps en compétition chacun sur un trampoline respectif avec des ensembles à capteur indépendants les uns des autres.

## Revendications

1. Procédé de mesure de paramètres physiques dans une compétition de trampoline (10), avec un système de mesure (1), qui comprend plusieurs ensembles (2) à capteur disposés dans différentes positions sur un trampoline (10), les ensembles (2) à capteur étant indépendants les uns des autres, pour une communication de signaux de données à une station de base (25) du système de mesure (1), chaque ensemble (2) à capteur comprenant un capteur de mouvement (3), une unité de traitement (4) et des moyens d'émission et réception (6) de signaux de données ou de commande, les signaux de données comprenant les mesures effectuées par le capteur de mouvement, **caractérisé en ce que** le procédé comprend les étapes de :
- pour un mode de compétition, activer chaque ensemble (2) à capteur,
- mesurer tout mouvement ou variations de mouvement dans le temps par le capteur de mouvement (3) de chaque ensemble (2) à capteur suite aux sauts effectués par un compétiteur sur un lit (21) du trampoline (10),
- traiter un ou des signaux de mesure du capteur de mouvement (3) dans l'unité de traitement (4), qui est un microcontrôleur, de chaque ensemble (2) à capteur, une base de temps de chaque microcontrôleur des ensembles (2) à capteur étant adaptée suite à une synchronisation transmise par un ordinateur (15) de la station de base (25) en communication avec chaque ensemble (2) à capteur,
- transmettre des signaux de mesures bien définis dans le temps de chaque ensemble (2) à capteur à destination de la station de base (25) du système de mesure (1),
- déterminer dans la station de base (25) suite aux différentes mesures reçues dans le temps de chaque ensemble (2) à capteur, un temps de vol de chaque saut du compétiteur, et une position de contact du compétiteur sur le lit (21) de manière à attribuer des points au compétiteur pour l'exécution d'un nombre de sauts déterminés lors de la compétition.

2. Procédé de mesure selon la revendication 1, **caractérisé en ce que** l'activation de chaque ensemble (2) à capteur est effectuée par un signal de commande transmis par une antenne d'émission (13) de la station de base (25) et reçu par une antenne (7) des moyens d'émission et réception (6) de chaque ensemble (2) à capteur.

3. Procédé de mesure selon la revendication 1, pour lequel le système de mesure (1) comprend au moins quatre ensembles (2) à capteur disposés chacun respectivement au niveau d'un de quatre coins (11) du lit (21) du trampoline (10), et l'unité de traitement, qui est un microcontrôleur (4), **caractérisé en ce que** dans le mode de compétition, chaque capteur de mouvement (3) des ensembles (2) à capteur effectue des mesures à une fréquence définie entre 1 kHz et 10 kHz, de préférence 2 kHz cadencée par le microcontrôleur (4), et **en ce qu'**une transmission des signaux de données de mesures à la station de base (25) intervient à chaque mesure effectuée pour déterminer dans la station de base (25) le temps de vol de chaque saut du compétiteur, et la position de contact du compétiteur sur le lit (21) du trampoline (10).

4. Procédé de mesure selon la revendication 3, **caractérisé en ce que** chaque ensemble (2) à capteur transmet des signaux de données avec une estampille temporelle de chaque mesure, qui sont captés par une antenne de réception (12) de la station de base (25).

5. Procédé de mesure selon la revendication 3, **caractérisé en ce que** chaque ensemble (2) à capteur transmet des signaux de données avec un numéro d'identification, qui sont captés par une antenne de réception (12) de la station de base (25) de manière à permettre à un ordinateur (15) de la station de base (25) de déterminer précisément la position de contact du compétiteur sur le lit (21) du trampoline (10) par les mesures des quatre ensembles (2) à capteur en combinaison.

6. Procédé de mesure selon l'une des revendications précédentes, **caractérisé en ce que** les différentes mesures effectuées dans le temps par le capteur de mouvement (3) de chaque ensemble (2) à capteur sont mémorisées dans une mémoire (5) reliée à l'unité de traitement (4), et **en ce qu'**un algorithme de détection est aussi mémorisé dans la mémoire (5) ou dans l'unité de traitement, qui est un microcontrôleur (4) pour détecter si le compétiteur durant la compétition est dans l'air ou non lors de chaque saut du compétiteur.

7. Procédé de mesure selon la revendication 3, pour lequel chaque capteur de mouvement (3) comprend au moins un accéléromètre et un gyroscope, **caractérisé en ce qu'**une détermination du temps de vol du compétiteur peut être déterminée par chaque ensemble (2) à capteur avant une transmission des signaux de données de mesures.

8. Procédé de mesure selon la revendication 1, pour lequel chaque ensemble (2) à capteur comprend une mémoire (5) de stockage des mesures du capteur de mouvement, une batterie (8) d'alimentation électrique des composants électroniques de l'ensemble (2) à capteur, **caractérisé en ce que** chaque ensemble (2) à capteur, qui comprend des moyens d'émission et réception (6) sans fil de signaux, envoie un signal de statut périodiquement, qui est capté par une antenne (12) de la station de base (25) et transféré à un ordinateur (15) de la station de base (25), qui peut connaître l'état du capteur de mouvement (3), le niveau de la batterie (8), l'espace de stockage de la mémoire (5).

9. Procédé de mesure selon la revendication 1, pour lequel chaque ensemble (2) à capteur comprend des moyens d'émission et réception (6) sans fil de signaux pour recevoir des signaux de commande transmis par une antenne d'émission (13) de la station de base (25), **caractérisé en ce que** les signaux de commande reçus permettent d'effectuer une sélection d'un mode compétition, où les ensembles (2) à capteur et des algorithmes de détection sont activés pour la compétition, une sélection d'un mode pause, où uniquement les capteurs de mouvement (3) des ensembles (2) à capteur et des algorithmes de détection sont désactivés, une sélection d'un mode arrêt, où chaque ensemble (2) à capteur est éteint, et un effacement de mémoire (5), où toutes les données mémorisées des ensembles (2) à capteur sont effacées avant une nouvelle compétition.

10. Système de mesure (1) de paramètres physiques dans une compétition de trampoline (10) pour la mise en oeuvre du procédé de mesure selon l'une des revendications précédentes, le système de mesure (1) comprenant plusieurs ensembles (2) à capteur disposés dans différentes positions sur un trampoline (10), les ensembles (2) à capteur étant indépendants les uns des autres, pour une communication de signaux de données à une station de base (25) du système de mesure (1), chaque ensemble (2) à capteur comprenant un capteur de mouvement (3), une unité de traitement (4) et des moyens d'émission (6) et réception de signaux de données ou de commande, les signaux de données comprenant les mesures effectuées par le capteur de mouvement (3), le système de mesure de paramètres physiques étant configuré de manière à réaliser les étapes de:
- pour un mode de compétition, activer chaque ensemble (2) à capteur,
- mesurer tout mouvement ou variations de mouvement dans le temps par le capteur de mouvement (3) de chaque ensemble (2) à capteur suite aux sauts effectués par un compétiteur sur un lit (21) du trampoline (10),
- traiter un ou des signaux de mesure du capteur de mouvement (3) dans l'unité de traitement (4), qui est un microcontrôleur, de chaque ensemble (2) à capteur, une base de temps de chaque microcontrôleur des ensembles (2) à capteur étant adaptée suite à une synchronisation transmise par un ordinateur (15) de la station de base (25) en communication avec chaque ensemble (2) à capteur,
- transmettre des signaux de mesures bien définis dans le temps de chaque ensemble (2) à capteur à destination de la station de base (25) du système de mesure (1),
- déterminer dans la station de base (25) suite aux différentes mesures reçues dans le temps de chaque ensemble (2) à capteur, un temps de vol de chaque saut du compétiteur, et une position de contact du compétiteur sur le lit (21) de manière à attribuer des points au compétiteur pour l'exécution d'un nombre de sauts déterminés lors de la compétition.

11. Système de mesure (1) selon la revendication 10, **caractérisé en ce que** l'unité de traitement de chaque ensemble (2) à capteur est un microcontrôleur (4) à base de temps pour cadencer les mesures effectuées par le capteur de mouvement (3), qui comprend au moins un accéléromètre et un gyroscope.

12. Système de mesure (1) selon la revendication 10, **caractérisé en ce que** chaque ensemble (2) à capteur comprend une mémoire pour mémoriser les différentes mesures du capteur de mouvement (3), et un algorithme de détection.

13. Système de mesure (1) selon la revendication 12, **caractérisé en ce que** chaque mesure effectuée par le capteur de mouvement (3) est mémorisée dans la mémoire (5) avec une estampille temporelle.

14. Système de mesure (1) selon la revendication 10, **caractérisé en ce qu'**une batterie (8) est prévue dans chaque ensemble (2) à capteur pour l'alimentation électrique des composants électroniques, et **en ce que** le capteur de mouvement (3) de chaque ensemble (2) à capteur est composé d'un accéléromètre triaxial, d'un gyroscope triaxial, et d'un magnétomètre triaxial.

## Patentansprüche

1. Verfahren zum Messen von physikalischen Parametern bei einem Trampolinwettkampf (10) mit einem Messsystem (1), das mehrere Sensoranordnungen (2) umfasst, die an unterschiedlichen Positionen an einem Trampolin (10) angeordnet sind, wobei die Sensoranordnungen (2) voneinander unabhängig sind, für eine Kommunikation von Datensignalen an eine Basisstation (25) des Messsystems (1), wobei jede Sensoranordnung (2) einen Bewegungssensor (3), eine Verarbeitungseinheit (4) und Mittel zum Senden und Empfangen (6) von Daten- oder Steuersignalen umfasst, wobei die Datensignale die vom Bewegungssensor durchgeführten Messungen umfassen, **dadurch gekennzeichnet, dass** das Verfahren die folgenden Schritte umfasst:
- Aktivieren jeder Sensoranordnung (2) für einen Wettkampfmodus,
- Messen jeder Bewegung oder von Bewegungsänderungen über die Zeit durch den Bewegungssensor (3) jeder Sensoranordnung (2) infolge der Sprünge, die von einem Wettkämpfer auf einem Sprungtuch (21) des Trampolins (10) durchgeführt werden,
- Verarbeiten eines oder mehrerer Messsignale des Bewegungssensors (3) in der Verarbeitungseinheit (4), bei der es sich um einen Mikrocontroller handelt, jeder Sensoranordnung (2), wobei eine Zeitbasis jedes Mikrocontrollers der Sensoranordnungen (2) infolge einer Synchronisation, die von einem mit jeder Sensoranordnung (2) in Kommunikation stehenden Computer (15) der Basisstation (25) übertragen wird, angepasst wird,
- Übertragen von zeitlich genau definierten Messsignalen von jeder Sensoranordnung (2) an die Basisstation (25) des Messsystems (1),
- Bestimmen, in der Basisstation (25) infolge der unterschiedlichen Messungen, die über die Zeit von jeder Sensoranordnung (2) empfangen werden, einer Flugzeit jedes Sprungs des Wettkämpfers und einer Kontaktposition des Wettkämpfers auf dem Sprungtuch (21), um dem Wettkämpfer Punkte für die Ausführung einer Anzahl von bestimmten Sprüngen beim Wettkampf zuzuteilen.

2. Messverfahren nach Anspruch 1, **dadurch gekennzeichnet, dass** das Aktivieren jeder Sensoranordnung (2) durch ein Steuersignal durchgeführt wird, das von einer Sendeantenne (13) der Basisstation (25) übertragen und von einer Antenne (7) der Sende- und Empfangsmittel (6) jeder Sensoranordnung (2) empfangen wird.

3. Messverfahren nach Anspruch 1, wobei das Messsystem (1) mindestens vier Sensoranordnungen (2), die jeweils an einer von vier Ecken (11) des Sprungtuchs (21) des Trampolins (10) angeordnet sind, und die Verarbeitungseinheit umfasst, bei der es sich um einen Mikrocontroller (4) handelt, **dadurch gekennzeichnet, dass** im Wettkampfmodus jeder Bewegungssensor (3) der Sensoranordnungen (2) Messungen mit einer definierten Frequenz zwischen 1 kHz und 10 kHz, bevorzugt 2 kHz, durchführt, die durch den Mikrocontroller (4) getaktet wird, und dadurch, dass eine Übertragung der Messdatensignale an die Basisstation (25) bei jeder durchgeführten Messung erfolgt, um in der Basisstation (25) die Flugzeit jedes Sprungs des Wettkämpfers und die Kontaktposition des Wettkämpfers auf dem Sprungtuch (21) des Trampolins (10) zu bestimmen.

4. Messverfahren nach Anspruch 3, **dadurch gekennzeichnet, dass** jede Sensoranordnung (2) Datensignale mit einem Zeitstempel jeder Messung überträgt, die von einer Empfangsantenne (12) der Basisstation (25) erfasst werden.

5. Messverfahren nach Anspruch 3, **dadurch gekennzeichnet, dass** jede Sensoranordnung (2) Datensignale mit einer Identifikationsnummer überträgt, die von einer Empfangsantenne (12) der Basisstation (25) erfasst werden, um es einem Computer (15) der Basisstation (25) zu ermöglichen, die Kontaktposition des Wettkämpfers auf dem Sprungtuch (21) des Trampolins (10) anhand der Messungen der vier Sensoranordnungen (2) in Kombination präzise zu bestimmen.

6. Messverfahren nach einem der vorstehenden Ansprüche, **dadurch gekennzeichnet, dass** die unterschiedlichen Messungen, die vom Bewegungssensor (3) jeder Sensoranordnung (2) über die Zeit durchgeführt werden, in einem Speicher (5) gespeichert werden, der mit der Verarbeitungseinheit (4) verbunden ist, und dadurch, dass in dem Speicher (5) oder in der Verarbeitungseinheit, bei der es sich um einen Mikrocontroller (4) handelt, auch ein Erkennungsalgorithmus gespeichert ist, um zu erkennen, ob der Wettkämpfer während des Wettkampfs bei jedem Sprung des Wettkämpfers in der Luft ist oder nicht.

7. Messverfahren nach Anspruch 3, wobei jeder Bewegungssensor (3) mindestens einen Beschleunigungsmesser und ein Gyroskop umfasst, **dadurch gekennzeichnet, dass** eine Bestimmung der Flugzeit des Wettkämpfers von jeder Sensoranordnung (2) vor einer Übertragung der Messdatensignale bestimmt werden kann.

8. Messverfahren nach Anspruch 1, wobei jede Sensoranordnung (2) einen Speicher (5) zum Speichern der Messungen des Bewegungssensors, eine Batterie (8) zur Stromversorgung der elektronischen Komponenten der Sensoranordnung (2) umfasst, **dadurch gekennzeichnet, dass** jede Sensoranordnung (2), die Mittel zum drahtlosen Senden und Empfangen (6) von Signalen umfasst, periodisch ein Statussignal sendet, das von einer Antenne (12) der Basisstation (25) erfasst und an einen Computer (15) der Basisstation (25) weitergeleitet wird, der den Zustand des Bewegungssensors (3), den Ladestand der Batterie (8), den Speicherplatz des Speichers (5) kennen kann.

9. Messverfahren nach Anspruch 1, wobei jede Sensoranordnung (2) Mittel zum drahtlosen Senden und Empfangen (6) von Signalen umfasst, um Steuersignale zu empfangen, die von einer Sendeantenne (13) der Basisstation (25) übertragen werden, **dadurch gekennzeichnet, dass** die empfangenen Steuersignale es ermöglichen, eine Auswahl eines Wettkampfmodus, bei dem die Sensoranordnungen (2) und Erkennungsalgorithmen für den Wettkampf aktiviert werden, eine Auswahl eines Pausenmodus, bei dem nur die Bewegungssensoren (3) der Sensoranordnungen (2) und Erkennungsalgorithmen deaktiviert werden, eine Auswahl eines Stoppmodus, bei dem jede Sensoranordnung (2) ausgeschaltet wird, und eine Speicherlöschung (5) durchzuführen, bei der alle gespeicherten Daten der Sensoranordnungen (2) vor einem neuen Wettkampf gelöscht werden.

10. System zum Messen (1) von physikalischen Parametern bei einem Trampolinwettkampf (10) zur Implementierung des Messverfahrens nach einem der vorstehenden Ansprüche, wobei das Messsystem (1) mehrere Sensoranordnungen (2) umfasst, die an unterschiedlichen Positionen an einem Trampolin (10) angeordnet sind, wobei die Sensoranordnungen (2) voneinander unabhängig sind, für eine Kommunikation von Datensignalen an eine Basisstation (25) des Messsystems (1), wobei jede Sensoranordnung (2) einen Bewegungssensor (3), eine Verarbeitungseinheit (4) und Mittel zum Senden und Empfangen (6) von Daten- oder Steuersignalen umfasst, wobei die Datensignale die vom Bewegungssensor (3) durchgeführten Messungen umfassen, wobei das System zum Messen von physikalischen Parametern so konfiguriert ist, dass es die folgenden Schritte ausführt:
- Aktivieren jeder Sensoranordnung (2) für einen Wettkampfmodus,
- Messen jeder Bewegung oder von Bewegungsänderungen über die Zeit durch den Bewegungssensor (3) jeder Sensoranordnung (2) infolge der Sprünge, die von einem Wettkämpfer auf einem Sprungtuch (21) des Trampolins (10) durchgeführt werden,
- Verarbeiten eines oder mehrerer Messsignale des Bewegungssensors (3) in der Verarbeitungseinheit (4), bei der es sich um einen Mikrocontroller handelt, jeder Sensoranordnung (2), wobei eine Zeitbasis jedes Mikrocontrollers der Sensoranordnungen (2) infolge einer Synchronisation, die von einem mit jeder Sensoranordnung (2) in Kommunikation stehenden Computer (15) der Basisstation (25) übertragen wird, angepasst wird, - Übertragen von zeitlich genau definierten Messsignalen von jeder Sensoranordnung (2) an die Basisstation (25) des Messsystems (1),
- Bestimmen, in der Basisstation (25) infolge der unterschiedlichen Messungen, die über die Zeit von jeder Sensoranordnung (2) empfangen werden, einer Flugzeit jedes Sprungs des Wettkämpfers und einer Kontaktposition des Wettkämpfers auf dem Sprungtuch (21), um dem Wettkämpfer Punkte für die Ausführung einer Anzahl von bestimmten Sprüngen beim Wettkampf zuzuteilen.

11. Messsystem (1) nach Anspruch 10, **dadurch gekennzeichnet, dass** die Verarbeitungseinheit jeder Sensoranordnung (2) ein Mikrocontroller (4) mit Zeitbasis ist, um die vom Bewegungssensor (3), der mindestens einen Beschleunigungsmesser und ein Gyroskop umfasst, durchgeführten Messungen zu takten.

12. Messsystem (1) nach Anspruch 10, **dadurch gekennzeichnet, dass** jede Sensoranordnung (2) einen Speicher, um die unterschiedlichen Messungen des Bewegungssensors (3) zu speichern, und einen Erkennungsalgorithmus umfasst.

13. Messsystem (1) nach Anspruch 12, **dadurch gekennzeichnet, dass** jede vom Bewegungssensor (3) durchgeführte Messung mit einem Zeitstempel im Speicher (5) gespeichert wird.

14. Messsystem (1) nach Anspruch 10, **dadurch gekennzeichnet, dass** in jeder Sensoranordnung (2) eine Batterie (8) zur Stromversorgung der elektronischen Komponenten, und dadurch, dass der Bewegungssensor (3) jeder Sensoranordnung (2) aus einem Drei-Achsen-Beschleunigungsmesser, einem Drei-Achsen-Gyroskop und einem Drei-Achsen-Magnetometer zusammengesetzt ist.

## Claims

1. Method for measuring physical parameters in a trampoline (10) competition, with a measuring system (1) that includes several sensor assemblies (2) arranged in different positions on a trampoline (10), the sensor assemblies (2) being independent of one another, for communication of data signals to a base station (25) of the measuring system (1), each sensor assembly (2) comprising a motion sensor (3), a processing unit (4) and means (6) for transmitting and receiving data or control signals, the data signals containing the measurements made by the motion sensor, **characterized in that** the method includes the steps of:
- for a competition mode, activating each sensor assembly (2),
- measuring any motion or variations in motion over time via the motion sensor (3) of each sensor assembly (2) following jumps performed by a competitor on a bed (21) of the trampoline (10),
- processing one or more measurement signals from the motion sensor (3) in the processing unit (4), which is a microcontroller, of each sensor assembly (2), a time base of each microcontroller of the sensor assemblies (2) being adapted as a result of a synchronization transmitted by a computer (15) of the base station (25) in communication with each sensor assembly (2),
- transmitting measurement signals clearly defined in time from each sensor assembly (2) to the base station (25) of the measuring system (1),
- automatically determining in the base station (25) following the various measurements received over time from each sensor assembly (2), a time of flight for each of the competitor's jumps, and a position of contact of the competitor on the bed (21) in order to award points to the competitor for the execution of a number of specific jumps during the competition.

2. Measuring method according to claim 1, **characterized in that** each sensor assembly (2) is activated by a control signal transmitted by a transmitting antenna (13) of the base station (25) and received by an antenna (7) of the transmitting and receiving means (6) of each sensor assembly (2).

3. Measuring method according to claim 1, wherein the measuring system (1) comprises at least four sensor assemblies (2) each respectively arranged at one of the four corners (11) of the bed (21) of the trampoline (10), and the processing unit, which is a microcontroller (4), **characterized in that**, in competition mode, each motion sensor (3) of the sensor assemblies (2) makes measurements at a defined frequency between 1 kHz and 10 kHz, preferably 2 kHz, clocked by the microcontroller (4), and **in that** transmission of the measurement data signals to the base station (25) occurs with every measurement made to determine in the base station (25) the time of flight of each of the competitor's jumps, and the position of contact of the competitor on the bed (21) of the trampoline (10).

4. Measuring method according to claim 3, **characterized in that** each sensor assembly (2) transmits data signals with a time stamp for each measurement, which are received by a receiving antenna (12) of the base station (25).

5. Measuring method according to claim 3, **characterized in that** each sensor assembly (2) transmits data signals with an identification number, which are received by a receiving antenna (12) of the base station (25) in order to allow a computer (15) of the base station (25) to precisely determine the position of contact of the competitor on the bed (21) of the trampoline (10) by means of the measurements of the four sensor assemblies (2) combined.

6. Measuring method according to one of the preceding claims, **characterized in that** the various measurements made over time by the motion sensor (3) of each sensor assembly (2) are stored in a memory (5) connected to the processing unit (4), and **in that** a detection algorithm is also stored in the memory (5) or in the processing unit, which is a microcontroller (4), to detect, during the competition, whether or not the competitor is in the air during each of the competitor's jumps.

7. Measuring method according to claim 3, wherein each motion sensor (3) comprises at least an accelerometer and a gyroscope, **characterized in that** the time of flight of the competitor can be determined by each sensor assembly (2) prior to transmission of the measurement data signals.

8. Measuring method according to claim 1, wherein each sensor assembly (2) comprises a memory (5) for storing the motion sensor measurements, and a battery (8) for powering the electronic components of the sensor assembly (2), **characterized in that** each sensor assembly (2), which comprises wireless signal transmitting and receiving means (6), periodically sends a status signal, which is received by an antenna (12) of the base station (25) and transferred to a computer (15) of the base station (25), which can obtain the status of the motion sensor (3), the battery (8) level and the storage space on the memory (5).

9. Measuring method according to claim 1, wherein each sensor assembly (2) comprises wireless signal transmitting and receiving means (6) for receiving control signals transmitted by a transmitting antenna (13) of the base station (25), **characterized in that** the received control signals allow selection of a competition mode, wherein the sensor assemblies (2) and detection algorithms are activated for the competition, selection of a standby mode, wherein only the motion sensors (3) of the sensor assemblies (2) and detection algorithms are deactivated, selection of a shutdown mode, wherein each sensor assembly (2) is off, and erasure of the memory (5), whereby all the data stored in the sensor assemblies (2) is erased before a new competition.

10. System (1) for measuring physical parameters in a trampoline (10) competition for implementation of the measuring method according to one of the preceding claims, wherein the measuring system (1) comprises several sensor assemblies (2) arranged in different positions on a trampoline (10), the sensor assemblies (2) being independent of one another, for communication of data signals to a base station (25) of the measuring system (1), each sensor assembly (2) comprising a motion sensor (3), a processing unit (4), and data or control signal transmitting and receiving means (6), the data signals containing the measurements made by the motion sensor (3), the system for measuring physical parameters being configured so as to carry out the steps of:
- for a competition mode, activating each sensor assembly (2),
- measuring any motion or variations in motion over time via the motion sensor (3) of each sensor assembly (2) following jumps performed by a competitor on a bed (21) of the trampoline (10),
- processing one or more measurement signals from the motion sensor (3) in the processing unit (4), which is a microcontroller, of each sensor assembly (2), a time base of each microcontroller of the sensor assemblies (2) being adapted as a result of a synchronization transmitted by a computer (15) of the base station (25) in communication with each sensor assembly (2),
- transmitting measurement signals clearly defined in time from each sensor assembly (2) to the base station (25) of the measuring system (1),
- automatically determining in the base station (25) following the various measurements received over time from each sensor assembly (2), a time of flight for each of the competitor's jumps, and a position of contact of the competitor on the bed (21) in order to award points to the competitor for the execution of a number of specific jumps during the competition.

11. Measuring system (1) according to claim 10, **characterized in that** the processing unit of each sensor assembly (2) is a microcontroller (4) with a time base for clocking the measurements made by the motion sensor (3), which comprises at least an accelerometer and a gyroscope.

12. Measuring system (1) according to claim 10, **characterized in that** each sensor assembly (2) comprises a memory for storing the various measurements of the motion sensor (3), and a detection algorithm.

13. Measuring system (1) according to claim 12, **characterized in that** each measurement made by the motion sensor (3) is stored in the memory (5) with a time stamp.

14. Measuring system (1) according to claim 10, **characterized in that** a battery (8) is provided in each sensor assembly (2) for powering the electronic components, and **in that** the motion sensor (3) of each sensor assembly (2) is composed of a triaxial accelerometer, a triaxial gyroscope, and a triaxial magnetometer.
